Europäisches Patentamt

European Patent Office

Office européen des brevets

(11) Numéro de publication: **0 345 859**
**A1**

## (12) DEMANDE DE BREVET EUROPEEN

(21) Numéro de dépôt: 89201352.5

(22) Date de dépôt: 29.05.89

(51) Int. Cl.⁴: **H01L 21/205** , **C30B 25/02** , **C30B 29/40**

(30) Priorité: **03.06.88 FR 8807428**

(43) Date de publication de la demande:
**13.12.89 Bulletin 89/50**

(84) Etats contractants désignés:
**DE FR GB NL**

(71) Demandeur: **LABORATOIRES D'ELECTRONIQUE ET DE PHYSIQUE APPLIQUEE L.E.P.**
**3, Avenue Descartes**
**F-94450 Limeil-Brévannes(FR)**

(84) **FR**

Demandeur: **N.V. Philips' Gloeilampenfabrieken**
**Groenewoudseweg 1**
**NL-5621 BA Eindhoven(NL)**

(84) **DE GB NL**

(72) Inventeur: **Guedon, Christophe**
**Société Civile S.P.I.D. 209 rue de l'Université**
**F-75007 Paris(FR)**
Inventeur: **Gentner, Jean-Louis**
**Société Civile S.P.I.D. 209 rue de l'Université**
**F-75007 Paris(FR)**

(74) Mandataire: **Landousy, Christian et al**
**Société Civile S.P.I.D. 209, Rue de l'Université**
**F-75007 Paris(FR)**

(54) **Procédé de réalisation de couches épitaxiales.**

(57) Procédé de réalisation d'un dispositif semiconducteur, incluant au moins la réalisation, par une méthode dite en phase vapeur, aux chlorures, de deux couches épitaxiales superposées, la couche inférieure 102, étant en un composé ternaire, et la couche supérieure 104, un composé binaire, l'un et l'autre en matériau semiconducteur du groupe III-V, caractérisé en ce que les conditions opératoires de température de dépôt et de fractions molaires des composés nécessaires à la formation des couches sont choisies telles que, aussi bien la couche inférieure en matériau ternaire que la couche supérieure en matériau binaire présentent avant, pendant et après le régime transitoire correspondant au passage de la couche inférieure à la couche supérieure, un taux de recouvrement maximal en atomes de chlore (Cl).

FIG. 4

## PROCEDE DE REALISATION DE COUCHES EPITAXIALES"

L'invention concerne un procédé de réalisation d'un dispositif semiconducteur, incluant au moins la réalisation, par une méthode dite en phase vapeur, aux chlorures, de deux couches épitaxiales superposées, la couche inférieure étant en un composé ternaire et la couche supérieure en un composé binaire, l'un et l'autre en matériau semiconducteur du groupe III-V.

L'invention trouve son application dans la réalisation d'hétérostructures GaInAs/InP pour les applications optoélectroniques, parmi lesquelles on peut citer les lasers intégrés, les photodiodes PIN, les photodiodes à avalanches, les structures à puits quantiques ou les super-réseaux, les guides de lumière enterrés, les modulateurs de phase intégrés etc.

Pour toutes ces applications envisagées, il est essentiel de réaliser, en composés semiconducteurs du groupe III-V, des couches épitaxiales superposées dont :
- la composition,
- la qualité électrique,
- la qualité cristallographique,
- l'épaisseur,
- l'épaisseur de la région d'interface entre deux couches.
sont extrêmement bien contrôlées.

Entre les méthodes connues de réalisation de couches épitaxiales, une méthode dite "croissance épitaxiale en phase vapeur aux chlorures a donné de très bons résultats concernant :
- la composition,
- la qualité électrique,
- la qualité cristallographique des couches épitaxiales réalisées en composés III-V.

Cependant jusqu'à ce jour, l'épaisseur des couches épitaxiales minces ainsi que l'épaisseur de la région d'interface entre deux couches de composés III-V différents étaient mal contrôlées, comme le montre la publication de C. Guedon et alii dans "Journal of Crystal Growth 79 (1986) North Holland, Amsterdam" pages 909-913.

Ce document décrit une méthode de croissance épitaxiale en phase vapeur aux chlorures pour réaliser des couches alternées de GaInAs et d'InP. Cette méthode comprend d'une part la décomposition thermique de trichlorure d'arsenic $AsCl_3$ et de trichlorure de phosphore $PCl_3$ dans un flux d'hydrogène pour obtenir de l'arsenic $As_4$ du phosphure $P_4$ et de l'acide chlorhydrique HCl. Les produits de la décomposition des trichlorures sont amenés ensuite à réagir sur des sources de matériau binaire d'arséniure de gallium GaAs et de phosphure d'indium InP respectivement, sources qui sont solides aux températures utilisées (700° à 800°C).

L'acide chlorhydrique formé lors de la décomposition des trichlorures réagit notamment avec ces sources pour donner du chlorure de gallium GaCl et de l'arsenic $AS_4$, et pour donner du chlorure d'indium InCl et du phosphore $P_4$ respectivement.

Cette méthode comprend d'autre part la formation d'acide chlorhydrique par la décomposition thermique de trichlorure d'arsenic $AsCl_3$ dans un four sous atmosphère d'hydrogène, suivie de la condensation de l'arsenic sur les parois froides d'un tube. L'acide chlorhydrique ainsi formé est amené, ainsi que le flux d'hydrogène, sur une source d'indium In, de telle manière que dans la région de cette source, il se produit par réaction de l'acide chlorhydrique, à haute température, sur l'indium, du chlorure d'indium et de l'hydrogène.

Selon le document cité, on dispose donc, pour la croissance des couches épitaxiales de GaInAs, :
- d'un flux de GaCl + $As_4$ + HCl
- d'un flux d'InCl
- d'un flux d'hydrogène
et pour la croissance épitaxiale des couches d'InP
- d'un flux d'InCl + $P_4$ + HCl
- d'un flux d'InCl
- d'un flux d'hydrogène.

Ce document enseigne que, à des températures de dépôt de l'ordre de 620 à 650°C, lors de la croissance épitaxiale d'une couche d'InP suivie d'une couche de GaInAs, il se forme une couche intermédiaire quaternaire d'une épaisseur de l'ordre de 1,6 nm pour 620°C et 1,2 nm pour 650°C, ce qui peut être acceptable pour les applications optoélectroniques envisagées.

Mais en revanche, lors de la croissance épitaxiale d'une couche épitaxiale de GaInAs, suivie de la croissance épitaxiale d'InP, il se forme une couche intermédiaire quaternaire d'une épaisseur de l'ordre de 7,9 nm pour une température de dépôt de 620°C et 5,5 nm pour une température de dépôt de 650°C.

Selon le document cité l'augmentation de la température de dépôt aurait un effet bénéfique sur la diminution de la couche d'interface indésirable et notamment une température de dépôt au moins égale à 650°C serait recommandée.

D'autres conditions seraient en outre préconisées pour obtenir la diminution de l'épaisseur de la couche d'interface telles que :
- l'augmentation des fractions molaires d'InCl et de GaCl dans la croissance de GaInAs pour obtenir la diminution du taux de croissance de cette couche ;
- la diminution du taux de croissance d'InP en utilisant seulement le flux d'InCl + $P_4$ provenant de l'action de HCl sur la source d'InP au lieu d'utiliser conjointement les flux d'InCl provenant de la source solide d'InP et de la source liquide d'In.

Malgré différents essais réalisés sous ces différentes conditions, les résultats publiés par le document cité restent mauvais et, notamment, une épaisseur de couche d'interface lors du passage de la couche de GaInAs à la couche d'InP n'est jamais obtenue inférieure à 5,5 nm.

Or pour la réalisation de dispositifs à puits quantiques par exemple, il est essentiel d'élaborer d'abord une couche de GaInAs de faible épaisseur, typiquement 10 nm, surmontée d'une couche d'InP de forte épaisseur, typiquement 500 nm. On voit donc que s'il se forme entre ces couches, une couche d'interface quaternaire indésirable qui est d'une épaisseur voisine de celle de la couche de GaInAs sous-jacente, les dispositifs envisagés ne peuvent pas être de bonne qualité.

Le même problème se pose pour la réalisation de tous les dispositifs qui incluent une couche de GaInAs comme couche tampon ou de confinement.

C'est pourquoi la présente invention propose un procédé de réalisation qui permet d'obtenir des couches d'interfaces de très faible épaisseur lors du passage d'une couche ternaire de composé III-V telle que GaInAs à une couche binaire de composé III-V telle que InP.

Selon l'invention, ce résultat est obtenu en se plaçant, dans un procédé tel que défini dans le préambule, dans des conditions opératoires où, aussi bien la couche inférieure en matériau ternaire que la couche supérieure en matériau binaire présentent avant, pendant et après le régime transitoire correspondant au passage de la couche inférieure à la couche supérieure. un taux de recouvrement maximal en atomes de chlore (Cl).

Dans la réalisation d'une couche d'arséniure de gallium et d'indium GaInAs suivie de la réalisation d'une couche de phosphure d'indium InP, ces conditions sont obtenues en choisissant, pour obtenir un fort taux de recouvrement en chlore (Cl) de la couche de GaInAs, une température de dépôt basse, et en choisissant pour obtenir un fort taux de recouvrement en chlore (Cl) de la couche d'InP, une pression de chlorure d'indium importante lors de la réalisation de la couche d'InP.

Selon l'invention, pour la réalisation de ces couches particulières, la températures de dépôt est considérée comme basse dans la gamme de 600 à 640° C, la pression d'InCl est considérée comme importante dans la gamme où la fraction molaire d'InCl qui réagit va de $2.10^{-3}$ à $2.10^{-2}$, et les facteurs température de dépôt de GaInAs et fraction d'InCl lors du dépôt d'InP sont choisis dans ces gammes en tenant compte du fait qu'ils coopèrent en raison inverse l'un de l'autre.

Dans ces conditions, les avantages suivants sont, entre autres, obtenus :

- le taux de croissance de la couche ternaire de GaInAs est faible, ce qui permet de bien contrôler la croissance de couche de faible épaisseur généralement voulue pour ce matériau (en général 10 nm souhaités) ;
- l'épaisseur de la couche d'interface de composition aléatoire quaternaire indésirable est d'environ 1 nm, ce qui représente 1/10 de l'épaisseur de la couche de GaInAs lorsque celle-ci a été choisie de 10 nm, et est donc parfaitement acceptable ;
- le taux de croissance de la couche binaire d'InP est au contraire important, ce qui est très satisfaisant puisque, en général, il est recherché de réaliser des couches d'InP de plus grande épaisseur ($\simeq$ 500 nm) que celle des couches ternaires inférieures.

L'invention sera mieux comprise au moyen de la description suivante illustrée par les figures annexées, parmi lesquelles :

- la figure 1 représente schématiquement un réacteur d'épitaxie en phase vapeur aux chlorures ;
- la figure 2 représente l'état atomique de la surface supérieure d'une couche épitaxiale de GaInAs en cours d'élaboration par la méthode en phase vapeur aux chlorures ;
- la figure 3 représente l'état atomique de la surface supérieure d'une couche épitaxiale d'InP en cours d'élaboration par la méthode en phase vapeur aux chlorures ;
- la figure 4 représente en coupe schématique une superposition de couches obtenue selon l'invention ;
- la figure 5a représente le taux de croissance de GaInAs à $T_D$ = 650° C en fonction de la fraction molaire de InCl ;
- la figure 5b représente le taux de croissance d'InP à $T_D$ = 650° C en fonction de la fraction molaire d'InCl.

Pour comprendre la présente invention, il est nécessaire de considérer d'abord les phénomènes physiques qui sont en jeu dans la réalisation des couches épitaxiales de matériau III-V élaborées par la méthode en phase vapeur aux chlorures. On constatera par les explications données ci-après, que ces phénomènes étaient déjà bien connus avant la présente invention, mais que cette connaissance avant conduit paradoxalement à des procédés de réalisation incluant des conditions opératoires complètement erronées.

Selon la présente invention au contraire, la connaissance des fonctions de chacun des éléments en jeu dans la croissance épitaxiale, c'est-à-dire la température de dépôt, et les pressions des composés gazeux, permet de faire coopérer ces éléments selon un agencement nouveau, résultant en une fonction nouvelle, qui produit un résultat nouveau et permet de résoudre le problème technique posé.

On a vu en effet, que selon l'art antérieur lors de la réalisation d'une couche de GaInAs sur une couche d'InP, on obtenait une couche d'interface en matériau quaternaire de composition aléatoire, de faible épaisseur, alors que, lors de la réalisation d'une couche d'InP sur une couche de GaInAs cette couche d'interface était 5 à 10 fois plus épaisse, ne permettant pas d'obtenir des dispositifs optoélectroniques de qualité satisfaisante.

Le problème technique résolu par la présente invention est donc d'abord de réduire l'épaisseur de la couche d'interface indésirable entre le matériau ternaire et le matériau binaire, et ensuite d'obtenir la maîtrise du taux de croissance de chacune de ces couches, en employant la méthode en phase vapeur aux chlorures, qui donne des couches de très bonne qualité pour un coût de fabrication modique en regard d'autres méthodes de fabrication de couches telles que la croissance par jet moléculaire (MBE).

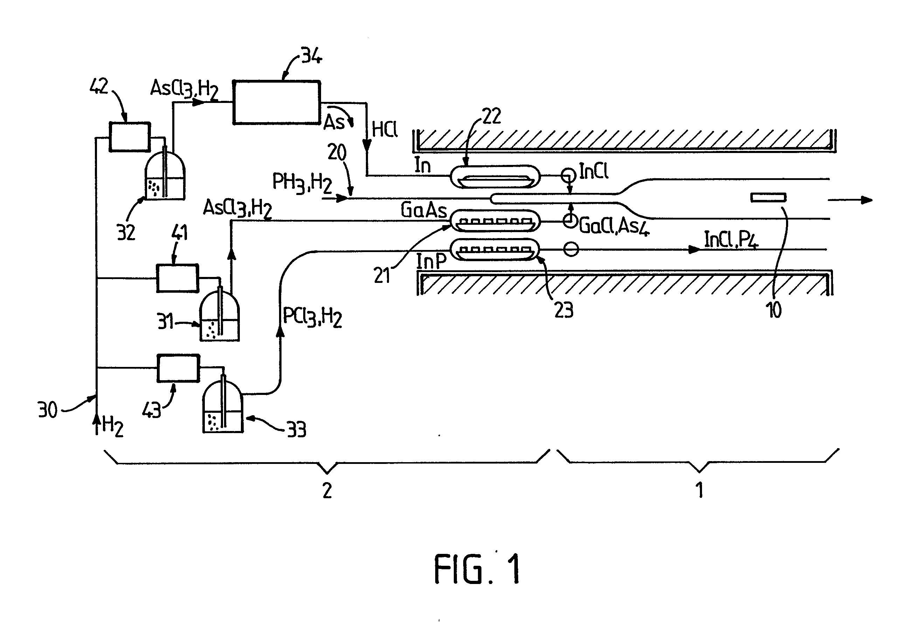

A cet effet, on décrira d'abord le réacteur d'épitaxie utilisé pour mettre en oeuvre l'invention. Un réacteur approprié à réaliser des couches épitaxiales de GaInAs et d'InP par la méthode aux chlorures est représenté sur la figure 1. D'autres dispositifs sont connus, tels que par exemple celui de la demande de brevet français N° 86 07 538 et sont également appropriés à cette réalisation.

En outre, d'autres couches de matériaux semiconducteurs, peuvent aussi être réalisées dans ces types de réacteurs, avec des méthodes similaires, pourvu qu'elles montrent des propriétés de croissance semblables.

Tel que représenté sur la figure 1, le réacteur comprend essentiellement une partie 1 qui reçoit l'échantillon ou chambre de dépôt et qui est portée à la température de dépôt et une partie 2 où sont élaborés les gaz réactants.

Dans l'exemple de réalisation décrit ci-après le substrat est d'abord préparé de la façon suivante. Une plaquette est découpée dans un lingot de phosphure d'indium (InP) lequel a été obtenu par la méthode Czochralski sous encapsulation. La plaquette est rodée puis polie mécanochimiquement avec une solution de brome méthanol. L'orientation cristallographique du plan de surface est (001) désorienté de 3° ou 6° vers le plan (110) de préférence autour de l'axe [110].

Dans le but de lui conférer un comportement semi-isolant, le substrat peut être par exemple dopé au fer (Fe), à une concentration d'environ $10^{16}$ atomes/cm$^3$. Des substrats de types de conductivité n peuvent aussi bien être utilisés, suivant le type de dispositifs semiconducteurs envisagés. Le dopage du substrat peut alors être réalisé au moyen d'atomes de soufre (S) à une concentration de $5.10^{18}$ à $10^{19}$ atomes/cm$^3$.

Le substrat doit ensuite être nettoyé, par exemple chimiquement, avant toute croissance épitaxiale. Un nettoyage chimique peut par exemple être effectué par la suite d'opérations de :
- dégraissage dans du trichloréthylène bouillant puis dans de l'isopropanol ;
- rinçage à l'eau désionisée ;
- décapage dans une solution de $H_2SO_4/H_2O_2/H_2O$ ;
- rinçage à l'eau désionisée ultra-pure.

L'expérience a montré que l'échantillon ainsi préparé est revêtu d'une fine couche d'oxyde d'environ 0,5 à 1 nm qui sera éliminée thermiquement dans le réacteur. Cette couche est composée essentiellement d'$InPO_4$ mais peut aussi être constituée d'$In_2O_3$, $In(OH)_3$.

L'échantillon, ou substrat d'InP, ainsi préparé est introduit dans la chambre 10 de dépôt du réacteur d'épitaxie où il doit être porté à la température de dépôt $T_d$.

Le composé InP possédant une température relativement basse d'évaporation congruente, la surface du substrat se dégrade sous atmosphère hydrogène à haute température. En effet au-delà de ce point congruent, le phosphore s'évapore plus rapidement que l'indium de la surface. Ainsi, selon qu'un échantillon d'InP est élevé en température dans une enceinte fermée, ou non, le point d'évaporation congruent est de 361°C et 365°C respectivement. A une température supérieure à ce point congruent, on observe une forte perte en $P_2$ à la surface.

Pour éviter cette dégradation de la surface, la surface est maintenue sous atmosphère phosphorée dès que la température du réacteur atteint 300°C, grâce à de la phosphine $PH_3$ introduite à l'entrée 20.

La seconde partie 2 du réacteur concerne les sources à partir desquelles sont préparés les gaz réactants.

Comme il est représenté sur la figure 1, de l'hydrogène gazeux est amené à l'entrée 30 à travers des filtres, respectivement 41, 42, 43, dans des bulleurs, respectivement 31, 32, 33, avec des débits respectivement $D_1$, $D_2$, $D_3$. Les bulleurs 31 et 32 contiennent le composé $AsCl_3$, et le bulleur 33 le composé $PCl_3$, à des températures respectivement $t_1$, $t_2$, $t_3$. D'autre part à l'entrée 20, de l'hydrogène gazeux est amené avec un débit $D_0$. La connaissance des différents débits de gaz, et des températures des composés dans les bulleurs, permet de connaître les quantités de matière entraînées ou fractions molaires de matériaux en jeu dans les réactions, à partir de relations connues de l'homme du métier, comme il sera exposé plus loin.

Les trichlorures sont d'abord décomposés thermiquement sous atmosphère d'hydrogène, selon les réactions :

$AsCl_3 + 3/2 H_2 - 3 HCl + 1/4 AS_4$    (1a)
$PCl_3 + 3/2 H_2 - 3 HCl + 1/4 P_4$    (3a)

Dans l'exemple de réalisation décrit ici, les produits des réactions (1a) et (3a) sont amenés respectivement sur des sources 21 et 23 respectivement de matériaux binaires de GaAs et d'InP, qui sont solides aux températures typiquement utilisées, c'est-à-dire $700°$ à $800°C$. Ces sources peuvent être remplacées par des sources métalliques liquides saturées en arsenic ou en phosphore.

Dans le cas des sources solides, les réactions s'écrivent respectivement :

$3 HCl + 3 GaAs - 3 GaCl + 3/4 AS_4 + 3/2 H_2$ (1b)

$3 HCl + 3 InP - 3 InCl + 3/4 P_4 + 3/2 H_2$    (3b)

Dans le cas des sources liquides, les réactions sont un peu plus complexes.

Pour mettre en oeuvre la croissance épitaxiale en phase vapeur aux chlorures selon l'invention, il faut en outre disposer d'une troisième source.

Cette troisième source est une source d'InCl. Du gaz HCl est d'abord préparé à partir, par exemple, de trichlorure d'arsenic $AsCl_3$ -ce qui garantit une grande pureté du gaz chlorhydrique- puis utilisé pour obtenir InCl.

La réaction d'obtention du gaz HCl est réalisée dans un four 34, il se forme alors de l'arsenic gazeux à haute température qui se dépose ensuite sur les parois froides d'un tube en quartz. La réaction de décomposition thermique du trichlorure d'arsenic sous atmosphère d'hydrogène s'écrit :

$ASCl_3 + 3/2 H_2 - 3 HCl + As$    (2a)    .

L'acide chlorhydrique est amené sur une source 22 d'indium liquide, d'où il résulte :

$HCl + In$ liquide $- InCl$    (2b)

La différence entre les pressions d'entrée, dans dans la région de dépôt épitaxiale sur le substrat 10, des différentes espèces gazeuses, et celles à l'équilibre thermodynamique avec le solide, est à l'origine de la croissance épitaxiale.

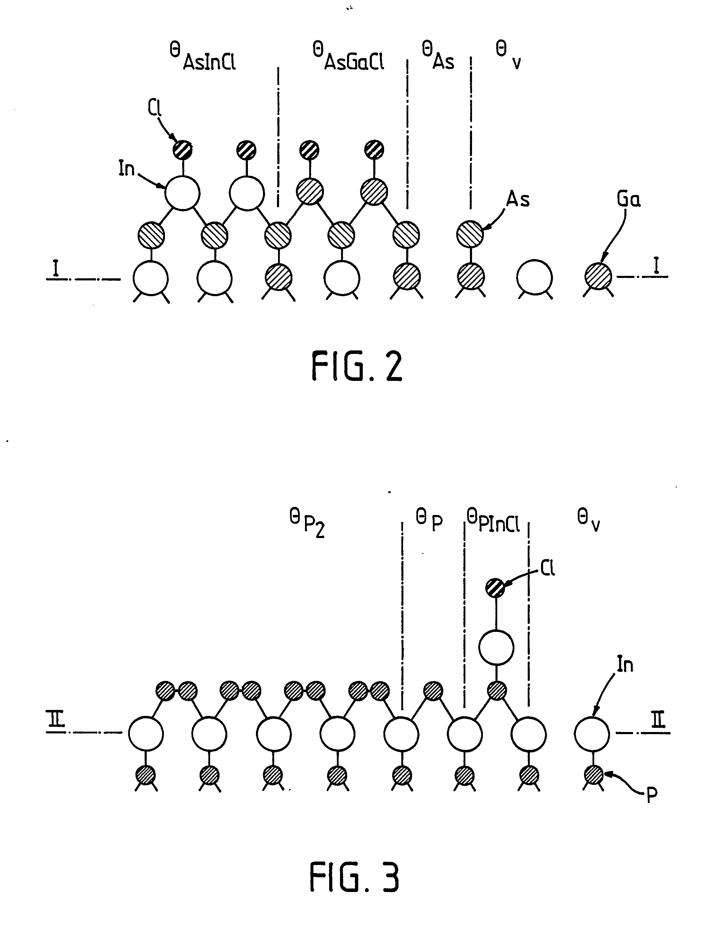

Considérons en premier la croissance épitaxiale du GaInAs. Telle que représentée sur la figure 2, si l'on prend comme plan de référence la couche d'atomes In et Ga, la couche qui se forme en premier immédiatement sur cette couche d'In Ga est formée en partie :

- d'espèces As avec un taux de recouvrement $\theta$-(As)

- d'espèces AsGaCl avec un taux de recouvrement $\theta(AsGaCl)$

- d'espèces AsInCl avec un taux de recouvrement $\theta(AsInCl)$

- de sites vacants avec un taux de recouvrement $\theta_V$.

D'après ce que nous avons vu précédemment, la croissance de GaInAs est due aux réactions :

$GaCl + 1/4 As_4 + 1/2 H_2 - GaAs + HCl$    (1c)
$InCl + 1/4 As_4 + 1/2 H_2 - InAs + HCl$    (2c)

Les réactions élémentaires mises en jeu entre la surface et la phase gazeuse sont :

un site vacant $+ 1/4 As_4 - As$ (adsorbé)    (6a)
un site As $+ GaCl - AsGaCl$ (adsorbé)    (6b)
un site As $+ InCl - AsInCl$    (6d)
un site $AsGaCl + H_2 - GaAs + HCl + H$ intersticiel    (6e) (désorption du chlore)
un site $AsInCl + H_2 - InAs + HCl + H$ intersticiel (6e)

L'atome de H restant n'intervient pas dans la réaction globale, ce qui serait le cas s'il occupait un site vacant. On peut ainsi penser qu'il se place en site intersticiel à la surface, et qu'il existe un équilibre avec $H_2$ (gaz). Mais cet équilibre n'a aucun effet sur le phénomène qui nous intéresse. On notera aussi que dans la réaction d'adsorption d'As, le résultat est un recouvrement en arsenic élémentaire As.

Il a été élaboré un modèle cinétique qui décrit la croissance de GaInAs en supposant que la cinétique globale correspond aux réactions (6b) et (6e), modèle selon lequel :

$\theta_V + \theta(As) + \theta(AsGaCl) + \theta(AsInCl) = 1$

et selon lequel le taux de croissance R(GaInAs) est donné

par :

$R(GaInAs) = R(GaAs) + R(InAs)$

Le taux de croissance R(GaAs) de GaAs est une fonction du taux de recouvrement $\theta(AsGaCl)$ et le taux de croissance R (InAs) de InAs est une fonction du taux de recouvrement $\theta(AsInCl)$ lesquels sont des fonctions, notamment des pressions p(GaCl) de GaCl et p(InCl) d'InCl respectivement, et de la température de dépôt $T_D$. On notera que, dans le procédé de réalisation mis en oeuvre ici, faut conserver un rapport de pression

p(InCl)/p(GaCl) = constante

Cette constante est déterminée pour assurer à l'arséniure de gallium et d'indium une formule :

$Ga_{0,47} In_{0,57}As$

propre à assurer l'accord de maille avec le phosphure d'indium InP.

L'expérimentation montre que, pour des températures de dépôt :

$T_D \geq 650°C$

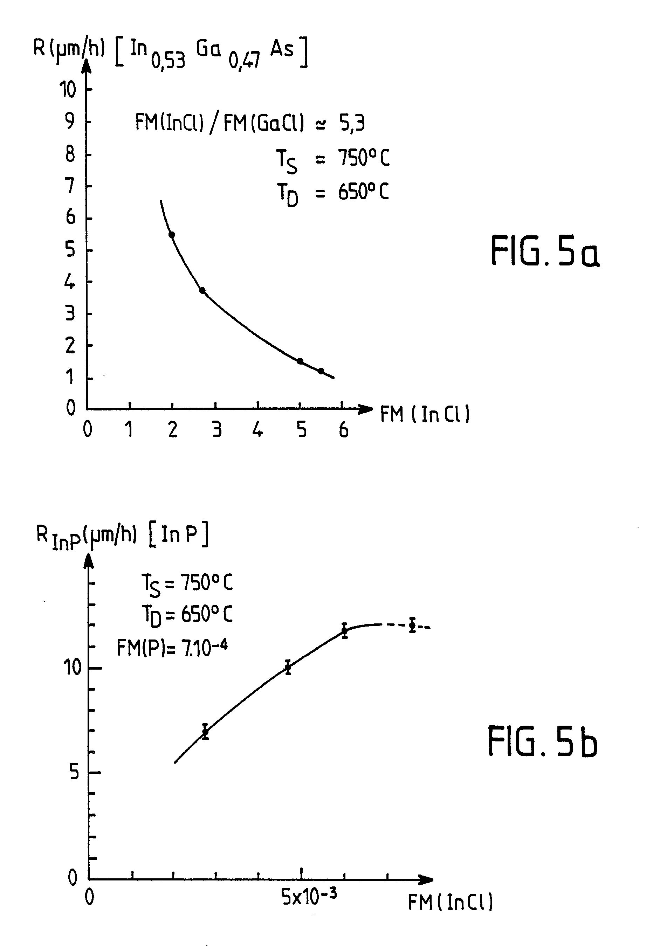

le taux de croissance R(GaInAs) de GaInAs est surtout fonction de la pression d'InCl. Notamment le taux de croissance de GaInAs augmente très vite lorsque la pression d'InCl diminue. Dans cette gamme de température, pour diminuer la vitesse de croissance, il faut donc augmenter la pression d'InCl, ce qui s'exprime aussi par l'augmentation de la fraction molaire d'InCl, FM(InCl), qui réagit comme il est montré sur la figure 5a pour la température de $650°C$.

Cette tendance traduit l'augmentation du taux de recouvrement en chlore
$\theta(AsInCl + \theta(AsGaCl)$

A la température de 650°C et aux températures supérieures un fort taux de recouvrement en chlore, provoquant le blocage de la surface recherchée n'est obtenu qu'aux extrémement fortes valeurs de la fraction molaire d'InCl FM(InCl), comme le montre la figure 5a, lesquelles résultent en inconvénients pratiques tels que, entre autres :
- un mauvais rendement en matières sources,
- un grand nombre de défauts dans les couches.

On notera que la relation entre la FM(Incl) et les pressions $p_1$(AsCl$_3$) et $p_3$(PCl$_3$) qui interviennent dans le procédé (voir relations 1a et 3a) est donnée, en fonction des débits $D_1$, $D_3$ dans les bulleurs 32 et 33, et du débit $D_0$ de l'hydrogène $H_2$ entrant dans le réacteur en 20 (voir la figure 1), par la formule

FM(InCl)$\simeq$[3 $D_1.p_1$(AsCl$_3$) + 3 $D_3.p_3$(PCl$_3$)-]$_r$(D· + $D_3$ + $D_c$)

Les pressions $p_1$ et $p_3$ sont elles-mêmes données, dans un tel système, par des lois d'évaporation connues de "Handbook of Chemistry and Physics, 51st Edition, 1970-1971, pp. D166-D169, published by : The Chemical Rubber Co".

On considérera en outre que :
FM(InCl) $\alpha$ p(InCl) la pression d'InCl.

Par contre lorsque la température de dépôt
$T_D < 650°C$
le taux de croissance R(GaInAs) de GaInAs est gouverné par la valeur des taux de recouvrements, et ceci même pour des valeurs modérées de la FM(InCl) telle que $2.10^{-3}$ à $4.10^{-3}$ par exemple.

Dans cette gamme de température de dépôt on observe que :
$\theta$(AsGaCl) + $\theta$(AsInCl) $> > \theta_v + \theta$(As)

Il y a donc peu de sites vacants et peu de sites As. On pourrait penser que du fait des forts taux de recouvrement en AsGaCl et AsInCl, la vitesse de croissance de GaInAs va être grande.

Il n'en est rien. Dans cette gamme de température de dépôt, la vitesse de croissance de GaInAs est faible. Cela est dû à l'existence d'interactions latérales attractives entre les complexes adsorbés AsGaCl et AsInCl. Lorsque $\theta$(AsGaCl) et $\theta$(AsInCl) deviennent importants, ces interactions inhibent la désorption du chlore par l'hydrogène (relations 6d et 6e) et limitent de ce fait la vitesse de croissance.

Considérons maintenant en second lieu, la croissance épitaxiale d'une couche d'InP.

D'après ce que nous avons vu précédemment la croissance d'InP est due à la réaction globale :
InCl + 1/4 P$_4$ + 1/2 H$_2$ InP + HCl (3c)

Telle que représentée sur la figure 3, si l'on prend comme plan de référence la couche d'atomes In, la couche qui se forme en premier, immédiatement sur la couche d'In, est composée :
- d'espèces P$_2$ avec un taux de recouvrement $\theta$-(P$_2$)
- d'espèces P avec un taux de recouvrement $\theta$(P)

- d'espèces PInCl avec un taux de recouvrement $\theta$-(PInCl)
- de sites vacants avec un taux de recouvrement $\theta_v$.

La croissance épitaxiale est due aux réactions élémentaires entre la surface et la phase gazeuse :
- un site InCl + 1/4 P$_4$ - PInCl (adsorbé) (7a)
- un site PInCl + H$_2$ - InP + HCl + H intersticiel (7b) (désorption du chlore)

L'énergie d'adsorption de P$_2$ sur un site est de l'ordre de -59 à -63 kcal/moles alors que celle de deux atomes de phosphore est seulement de -28 kcal/moles. De ce fait, le taux de recouvrement de la molécule P$_2$ est très supérieur à celui du phosphore monoatomique
$\theta$(P$_2$) $> > \theta$(P)

D'autre part, l'énergie de la liaison P-P de la molécule P$_2$ est estimée à -105 kcal/mole. Cette molécule sera donc très stable.

D'après la figure 3, pour qu'il y ait croissance épitaxiale d'InP, il faut augmenter $\theta$(PInCl) et il faut diminuer $\theta$(P$_2$). La vitesse de croissance d'InP est maximale lorsque le taux de recouvrement $\theta$(PInCl) est maximal, dans le cas où $\theta$(P$_2$) est grand. Ceci est très différent de la croissance de GaInAs, du fait du recouvrement important en P$_2$, qui domine et rend négligeables les interactions entre complexes adsorbés PInCl. Dans le cas de GaInAs, l'effet des interactions entre AsGaCl et AsInCl conduit à un maximum de R(GaInAs), le taux de croissance de GaInAs pour $\theta$(Cl) = 1/2. Ce n'est pas le cas pour InP aussi longtemps que $\theta$(P$_2$) $\simeq$ 1.

De plus, l'expérimentation montre que, si l'on fait varier la température de dépôt $T_D$, contrairement à ce qui se passe lors de la croissance de GaInAs, les taux de recouvrements restent à peu près constants, du fait que $\theta$(P$_2$) domine
[ $\theta$(P$_2$) $\simeq$ 1].

Si l'on veut faire varier le taux de croissance d'InP, il faut donc agir sur d'autres facteurs.

En calculant le taux de croissance d'InP à partir de la relation (7b), il s'avère que ce taux est, entre autres, fonction des pressions p(P), p(InCl).

Comme il est montré sur la figure 5b, à pression de P constante, le taux de croissance d'InP augmente lorsque la pression d'InCl augmente, car $\theta$(PInCl) augmente. Une sursaturation n'est visible qu'aux très fortes valeurs de FM(InCl).

L'expérimentation montre que $\theta$(PInCl) est maximal pour une pression d'InCl correspondant à une fraction molaire d'InCl, FM(InCl) $\simeq 7.10^{-3}$, dans le cas de la figure 5b.

Analysons enfin les conditions qui apparaissent au moment où l'on cesse la croissance de GaInAs et où l'on commence la croissance d'InP.

La couche quaternaire de composition variable et de forte épaisseur qui apparaissait selon l'art antérieur, au cours de cette étape, était due au fait que ce régime transitoire de croissance était incontrôlé et incontrôlable.

Selon l'invention, l'utilisation d'une température de dépôt $T_D < 650°C$ est un élément essentiel pour réussir le blocage de la surface, en restant dans une gamme de $FM(InCl) < 5.10^{-3}$ qui procure les meilleurs résultats. Et cet élément essentiel doit coopérer avec un autre élément essentiel pour obtenir le résulat espéré.

Il faut comprendre que, selon l'art antérieur toutes les conditions étaient réunies pour obtenir qu'à la fois la vitesse de croissance de GaInAs et InP soient faibles.

Ce résultat était obtenu :
- ou bien en choisissant une température de dépôt élevée (650°C) et une pression d'InCl (ou fraction molaire d'InCl) forte pour la croissance de GaInAs, et faible (due à l'utilisation d'une seule source) pour la croissance d'InP ;
- ou bien en choisissant une température de dépôt basse (620°C), avec toujours une pression d'InCl (ou fraction molaire d'InCl) faible pour la croissance d'InP.

Cela résultait en de nombreux sites vacants dans la couche de GaInAs si $T_D = 650°C$ était choisie, et en de nombreux sites vacants dans la couche d'InP dans les deux cas, la molécule $P_2$ ne bloquant pas suffisamment la surface d'InP contrairement à ce qui était prévu.

Dans l'un comme dans l'autre cas, la vitesse de croissance de la couche quaternaire d'interface était élevée car cette couche de composition aléatoire croissait rapidement à partir des sites vacants.

Selon l'invention au contraire :
- d'une part la température de dépôt $T_D$ est choisie $< 650°C$, de manière à ce que le taux de croissance de la couche de GaInAs soit faible et à ce que le taux de sites vacants soit bas. Ces conditions se répercutent sur le régime transitoire qui est influencé par les conditions initiales, ou conditions qui existent juste avant le commencement de la croissance d'InP.
- d'autre part la pression d'InCl lors du dépôt d'InP est augmentée de manière à ce que la surface reste bloquée par Cl, présentant également peu de sites vacants dès le commencement de la croissance d'InP et lors de cette croissance. Ceci est obtenu en utilisant, lors de la croissance d'InP à la fois la source solide d'InP et la source liquide d'In. Alors :
$\theta(PInCl) >> \theta(P) + \theta_V$, le taux de recouvrement en $P_2$ étant indifférent, puisque cette molécule $P_2$ bloque partiellement la surface, ce qui empêche aussi partiellement une croissance incontrôlée. Le taux de croissance d'InP est alors très grand contrairement à l'art antérieur. Ceci n'est pas un inconvénient, contrairement à ce qui avait été imaginé antérieurement.

Dans ces conditions, le régime transitoire à fort taux de croissance ne peut pas s'amorcer et la couche d'interface en composé quaternaire a une très faible épaisseur.

Il faut noter en outre qu'une forte pression d'InCl est aussi favorable à l'augmentation des taux de recouvrement $\theta(AsGaCl)$ et $\theta(AsInCl)$ lors de la croissance de GaInAs, et à un faible taux de croissance de GaInAs comme il a été dit précédemment.

Dans ces conditions des dispositifs semiconducteurs de bonne qualité peuvent être obtenus, et notamment des puits quantiques présentant une première couche de GaInAs de 10 nm suivie d'une couche d'InP d'environ 500 nm, avec une interface inférieure à 1 nm.

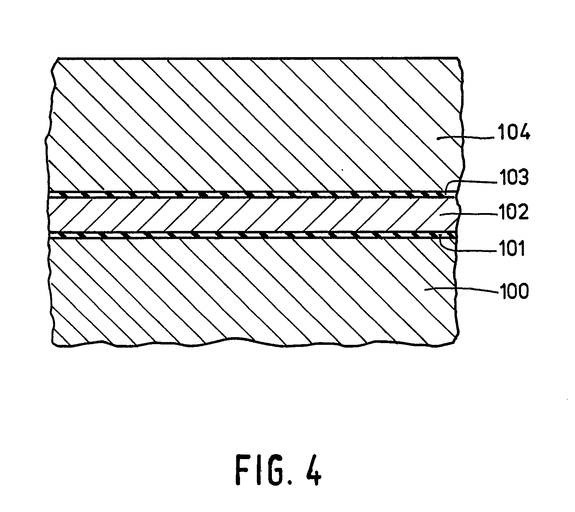

La figure 4 montre, réalisées sur une couche épitaxiale 100 en InP, une couche épitaxiale 102 en InGaAs, d'épaisseur de l'ordre de 10 nm suivie d'une couche épitaxiale 104 en InP, de forte épaisseur par exemple 500 nm. Les couches 101 et 103 sont des couches quaternaires qui apparaissent lors des transitions. Selon l'invention, elles sont de très faible épaisseur, de l'ordre de 1 nm.

Les conditions optimales seront obtenues avec :
- une température de dépôt $T_D \simeq 620°$ ou au moins comprise entre 600° et 640°C.
- une pression d'InCl forte aussi bien pendant la croissance de GaInAs que pendant la croissance d'InP, correspondant à une fraction molaire d'InCl FM (InCl) de l'ordre de $2,7.10^{-3}$. ou au moins comprise entre $2.10^{-3}$ et $4.10^{-3}$.

Pour obtenir les fractions molaires d'InCl voulues selon l'invention,
- pour réaliser la couche d'arséniure de gallium et d'indium (GaInAs), on appliquera dans la chambre du réacteur simultanément le produit de la source 21 d'arséniure de gallium (GaAs) et celui de la source 22 d'indium (In) ;
- pour réaliser la couche de phosphure d'indium (InP), on appliquera dans la chambre du réacteur simultanément le produit de la source 23 de phosphure d'indium (InP) et celui de la source 22 d'indium (In).

La fraction molaire de GaCl utilisée pour la croissance de GaInAs dans les conditions précédemment décrites [FM(InCl)) $\simeq 2,7.10^{-3}$ et $T_D = 620°C$] sera avantageusement :
$FM(GaCl) \simeq 3,2 . 10^{-3}$
et la fraction molaire de P utilisée pour la croissance d'InP dans ces mêmes conditions sera :
$FM(P) \simeq 1,5 . 10^{-3}$.

Ces conditions résultent en une vitesse de croissance de GaInAs de l'ordre de 2 $\mu$m/h. suffisamment faible pour bien dominer l'élaboration d'une couche de 10 nm d'épaisseur, et en une vitesse de croissance d'InP forte de l'ordre de 20 à 25 μm/h., contrairement à l'art antérieur, et favorable à l'élaboration de couches d'InP de forte épaisseur telle que 500 nm, ou plus.

Il est important de remarquer que les conditions opératoires de l'invention ne sont pas extrêmes ; elles sont donc faciles à mettre en oeuvre. Pour ces conditions :
- les matériaux obtenus présentent une bonne qualité électrique ;
- les taux de croissance sont bien contrôlés et reproductibles ;
- la composition du ternaire est bien contrôlée ;
- l'élaboration d'une interface InP-GaInAs est aussi de très bonne qualité ;
- il n'y a pas d'interruption de croissance entre les couches, ce qui résulte en la possibilité d'automatisation pour la réalisation de puits quantiques multiples, et ce de manière reproductible.

Enfin, il faut tenir compte de conditions annexes. Tout d'abord les sources sont elles-mêmes portées à des températures élevées qui ont une influence sur les vitesses de croissance, notamment sur la croissance de GaInAs. Pour conserver à GaInAs une vitesse de croissance faible, les températures des sources doivent être de l'ordre de 700 à 720°C, par exemple de 705°C pour $T_D$ = 620°C. Dans le cas où les températures des sources augmentent, la vitesse de croissance de GaInAs augmenterait aussi. Une différence de l'ordre de 80°C à 100°C entre température de sources et $T_D$ est parfaitement convenable.

## Revendications

1. Procédé de réalisation d'un dispositif semiconducteur, incluant au moins la réalisation, par une méthode dite en phase vapeur, aux chlorures, de deux couches épitaxiales superposées, la couche inférieure étant en un composé ternaire et la couche supérieure en un composé binaire, l'un et l'autre en matériau semiconducteur du groupe III-V, caractérisé en ce que les conditions opératoires de température de dépôt et de fractions molaires des composés nécessaires à la formation des couches sont choisies telles que, aussi bien la couche inférieure en matériau ternaire que la couche supérieure en matériau binaire présentent avant, pendant et après le régime transitoire correspondant au passage de la couche inférieure à la couche supérieure, un taux de recouvrement maximal en atomes de chlore (Cl).

2. Procédé selon la revendication 1, caractérisé en ce que la couche épitaxiale inférieure est en arséniure de gallium et d'indium de formule $Ga_{0,47}In_{0,53}As$ et la couche supérieure est en phosphure d'indium InP.

3. Procédé selon la revendication 2, caractérisé en ce que, les conditions opératoires incluent, pour obtenir un fort taux de recouvrement en chlore (Cl) de la couche de GaInAs, une température de dép : $T_D$ des couches basse, et, pour obtenir un fort taux de recouvrement en chlore (Cl) de la couche d'InP, une fraction molaire de chlorure d'indium, FM(InCl), importante lors de la réalisation de la couche d'InP.

4. Procédé selon la revendication 3, caractérisé en ce que, la température de dépôt $T_D$ est considérée comme basse dans la gamme de 600 à 640°C, la fraction molaire d'InCl qui réagit est considérée comme importante dans la gamme de $2.10^{-3}$à $4.10^{-3}$, et les facteurs température de dépôt $T_D$ et fraction molaire d'InCl, FM(InCl), lors du dépôt du phosphure d'indium InP, sont choisis dans ces gammes en tenant compte du fait que ces facteurs coopèrent en raison inverse l'un de l'autre.

5. Procédé selon la revendication 4, caractérisé en ce que la fraction molaire d'InCl est choisie de $2,7.10^{-3}$.

6. Procédé selon la revendication 5, caractérisé en ce que la température de dépôt $T_D$ est choisie de 620°C.

7. Procédé selon la revendication 6, caractérisé en ce que les sources nécessaires à la mise en oeuvre de la méthode dite en phase vapeur aux chlorures comprennent d'abord un bulleur de trichlorure d'arsenic ($AsCl_3$), et un bulleur de trichlorure de phosphore ($PCl_3$), portés à une température suffisamment élevée pour que des flux d'hydrogène appliqués à ces bulleurs entraînent des quantités de matière respectivement $AsCl_3$ et $PCl_3$ qui sont décomposées puis sont amenées à réagir sur des sources solides dites première et seconde sources respectivement d'arséniure de gallium (GaAs) et de phosphure d'indium (InP), portées à une température plus élevée $T_S$ que la température de dépôt $T_D$, sources à partir desquelles on dispose respectivement de chlorure de gallium (GaCl) + $As_4$ et de chlorure d'indium (InCl)$P_4$, gazeux et comprennent ensuite un bulleur de trichlorure d'arsenic ($AsCl_3$) porté à une température suffisamment élevée pour qu'un flux d'hydrogène appliqué à ce bulleur entraîne une quantité de matière ($AsCl_3$) qui est décomposée pour produire de l'acide chlorydrique gazeux, lequel est porté sur une source d'indium liquide dite troisième source portée à la température $T_S$, source à partir de laquelle on dispose de chlorure d'indium (InCl) gazeux et en ce que pour obtenir la fraction molaire d'InCl requise le produit de la troisième source est appliqué en même temps que le produit de la première source pour l'élaboration de la couche d'arséniure de gallium (GaInAs) et le produit de la troisième source est appliqué en même temps que le produit de la seconde source pour l'élaboration de la couche de phosphure d'indium (InP).

8. Procédé selon la revendication 7, caractérisé en ce que la température des sources $T_S$ est supérieure de 80 à 100 °C à celle de la température de dépôt $T_D$.

9. Procédé selon la revendication 8, caractérisé en ce que les couches respectivement d'arséniure de gallium et d'indium (GaInAs) et de phosphure d'indium (InP) sont déposées sur un substrat de phosphure d'indium (InP) et en ce que le rapport de la pression partielle de chlorure d'indium à la pression partielle de chlorure de gallium est prévu pour obtenir des couches d'arséniure de gallium de composition $Ga_{0,47}In_{0,57}As$ permettant l'accord de maille avec le substrat.

FIG. 1

1-Ⅳ-PHF 88-542

FIG. 2

FIG. 3

104
103
102
101
100

FIG. 4

FIG. 5a

FIG. 5b

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| A | JAPANESE JOURNAL OF APPLIED PHYSICS, Supplements 16th International Conference Solid State Devices and Materials, Kobe, 30 août - 1 septembre 1984, pages 567-570, Tokyo, JP; J. KOMENO et al.: "InGaAs/InP superlattice grown by vapor-phase epitaxy and its applications" * Résumé; figures 1,6; page 568, colonne de gauche, paragraphe 1 * | 1-9 | H 01 L  21/205 C 30 B  25/02 C 30 B  29/40 |
| A | JOURNAL OF CRYSTAL GROWTH, vol. 66, no. 1, janvier-février 1984, pages 73-82, Elsevier Science Publishers B.V. (North-Holland Physics Publishing Division), Amsterdam, NL; H. JÜRGENSEN et al.: "Vapour phase growth of InP from the In-PH3-HCl-H2 system" * Résumé; figure 1; page 79, colonne de gauche, paragraphe 3 - page 80, colonne de gauche, paragraphe 3 * | 1-9 | |
| D,A | JOURNAL OF CRYSTAL GROWTH, vol. 79, 1986, pages 909-913, Elsevier Science Publishers B.V. (North-Holland Physics Publishing Division), Amsterdam, NL; C. GUEDON et al.: "Control of interface formation during growth of InGaAs/InP heterostructures by chloride vapour phase epitaxy" * Résumé * | 1-9 | **DOMAINES TECHNIQUES RECHERCHES (Int. Cl.4)** H 01 L C 30 B |
| A | GB-A-2 192 198  (NTT) * Résumé; figures 5,20,40,42 * | 1 | |

Le présent rapport a été établi pour toutes les revendications

| Lieu de la recherche | Date d'achèvement de la recherche | Examinateur |
|---|---|---|
| LA HAYE | 19-09-1989 | GORI P. |

EPO FORM 1503 03.82 (P0402)